(19) Europäisches Patentamt
European Patent Office
Office européen des brevets

(11) Numéro de publication: **0 027 758**
**A1**

(12) # DEMANDE DE BREVET EUROPEEN

(21) Numéro de dépôt: **80401426.4**

(51) Int. Cl.$^3$: **H 03 G 3/20**

(22) Date de dépôt: **07.10.80**

(30) Priorité: **17.10.79 FR 7925804**

(43) Date de publication de la demande:
**29.04.81 Bulletin 81/17**

(84) Etats Contractants Désignés:
**AT BE CH DE GB IT LI NL SE**

(71) Demandeur: **THOMSON-CSF**
**173, Boulevard Haussmann**
**F-75360 Paris Cedex 08(FR)**

(72) Inventeur: **Eumurian, Grégoire**
**"THOMSON-CSF" SCPI 173, Bld Haussmann**
**F-75360 Paris Cedex 08(FR)**

(74) Mandataire: **Eisenbeth, Jacques Pierre et al,**
**"THOMSON-CSF" - SCPI 173, bld Haussmann**
**F-75360 Paris Cedex 08(FR)**

(54) **Dispositif de contrôle automatique de gain à action optique dans un système de transmission de signaux électriques par liaison optique.**

(57) Un atténuateur optique (24) à cristal liquide d'opacité variable est introduit dans la liaison optique (6), avec un circuit électrique de commande (23) inséré dans une boucle de contre réaction disposée en sortie de l'amplificateur vidéo fréquence (9) connecté en sortie de la liaison optique.

Application à l'électronique rapide.

./...

EP 0 027 758 A1

Croydon Printing Company Ltd.

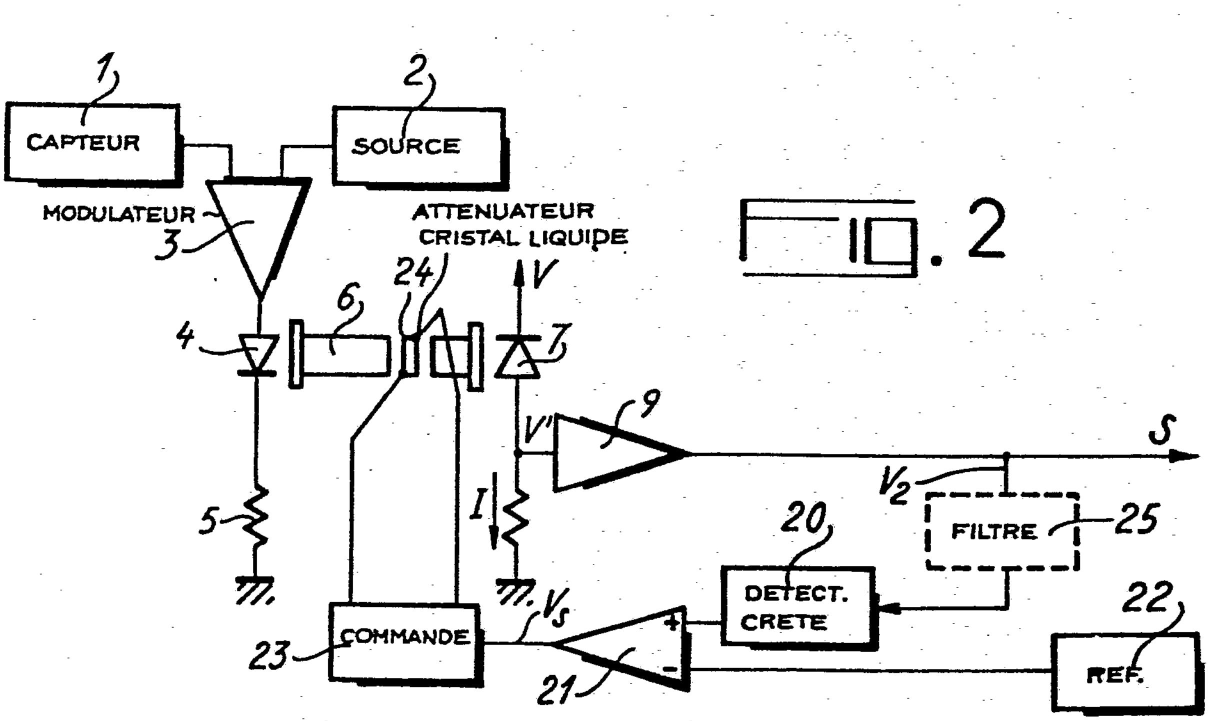
1
CAPTEUR
2
SOURCE
MODULATEUR
3
ATTENUATEUR
CRISTAL LIQUIDE
24
6
4
V
7
V'
9
S
$V_2$
I
5
FILTRE
25
20
DETECT.
CRETE
22
$V_s$
COMMANDE
23
+
-
21
REF.

FIG. 2

# DISPOSITIF DE CONTROLE AUTOMATIQUE DE GAIN A ACTION OPTIQUE DANS UN SYSTEME DE TRANSMISSION DE SIGNAUX ELECTRIQUES PAR LIAISON OPTIQUE

La présente invention concerne un dispositif de contrôle automatique de gain à action optique, plus particulièrement utilisé dans un système de transmission de signaux électriques comportant une liaison optique.

Le système de transmission dans lequel agit le dispositif suivant l'invention est plus particulièrement susceptible d'être soumis à des signaux de forte puissance.

Il est des domaines, principalement celui connu sous le nom d'électronique rapide dans lequel on est amené à traiter après qu'ils aient été détectés puis transmis, des signaux impulsionnels pouvant être de très faible durée, de récurrence également très faible et dont la forme initiale peut ne pas être connue, mais qu'il faut néanmoins pouvoir reconstituer avec une certaine précision lors du traitement. Ceci peut être le cas dans des transmissions de signaux numériques de l'ordre de la centaine de mégabits à très large bande passante de l'ordre par exemple de 500 Mcs.

Dans de telles transmissions, les signaux captés sont transformés en signaux optiques à l'aide d'émetteurs optiques rapides du type diode laser, permettant d'obtenir des liaisons à large bande pouvant aller de 100 Mégahertz à 1 Gigahertz environ. Ces liaisons optiques sont faites par des fibres optiques qui représentent par rapport à des liaisons électriques l'avantage d'un isolement galvanique et d'une bande passante étendue. Par contre ces liaisons par fibres optiques représentent l'inconvénient d'apporter une atténuation aux signaux transmis pouvant varier notablement au cours de la transmission. Ceci est dû au fait que les connecteurs optiques utilisés sont extrêmement sensibles aux tolérances mécaniques, à la poussière, au vieillissement et également au fait que certaines fibres optiques, du type multi-brins, peuvent avoir un nombre variable de fibres cassées qui atténuent encore la transmission de la

lumière. A ces variations de niveau, viennent s'ajouter les variations produites par les éléments d'émission et de réception.

L'élément d'émission est le transducteur qui recevant du capteur le signal à traiter, le transforme en un signal optique. D'une façon générale, cet élément d'émission peut être un laser solide ou une diode électroluminescente qui présente une pente de conversion courant-puissance optique variable dans le temps. Le récepteur optique, recevant les signaux transmis par les fibres constituant la liaison optique émetteur-récepteur, peut utiliser deux types de diodes, PIN ou à avalanche. Les diodes PIN sont stables en température et en fonction de la tension de polarisation. Les photodiodes à avalanche qui présentent une sensibilité environ 100 fois plus grande à la lumière, sont en revanche très sensibles aux variations de température et de tension.

Cette revue des inconvénients présentés par les systèmes de transmission utilisant des liaisons optiques opposés aux avantages que comporte l'utilisation de telles liaisons, impose que l'on se soucie de la stabilité des systèmes. Dans les systèmes, les éléments d'émission et de réception sont généralement stabilisés par des boucles de régulation. Les variations de niveau encore existantes proviennent alors presque exclusivement des liaisons optiques. Pour s'affranchir des variations de la puissance d'émission, de celle des pertes des connecteurs et des variations du rendement du récepteur, on a proposé de coder l'information à transmettre, soit en modulation de fréquence, soit en PCM (modulation par codage d'impulsions). Cependant ces codages nécessitent des bandes de transmission allant de 3 à 10 fois la bande utile. Par contre la modulation en amplitude de l'intensité optique émise nécessite un canal d'une largeur identique à la bande à transmettre mais toute variation de l'atténuation du canal joue directement sur le signal reçu.

Voulant ainsi connaître avec une plus ou moins bonne précision suivant le cas, les pertes subies par les signaux dans la liaison optique, pour pouvoir, en jouant sur le gain, rétablir le niveau du signal à sa valeur àl'entrée de la liaison, on superpose au signal à

traiter appelé signal utile, un signal pilote ou de calibrage de niveau déterminé et connu, situé soit en dehors de la bande passante du signal utilisé, soit dans sa bande. Les atténuations subies par le signal pilote étant identiques à celles subies par le signal utile, il est possible à la réception de rétablir le niveau du signal utile.

A la réception, le signal pilote est analysé, qu'il soit extrait du signal composite qui comprend le signal utile et le signal pilote ou qu'il ait été transmis indépendamment du signal utile, et après détection, commande un dispositif à gain variable.

La figure 1 rappelle de façon schématique un tel dispositif de l'art antérieur fonctionnant en numérique. Le capteur 1 reçoit le signal utile qui de façon générale est de faible durée et de niveau inconnu et le transmet sous forme électrique à un dispositif modulateur 3 qui reçoit de la source 2, le signal pilote $S_p$ ayant une forme et une amplitude fixes. Le dispositif de modulation superpose le signal utile $S_u$ et le signal pilote $S_p$ et délivre un signal composite $S_c$ qui frappe par exemple une diode électroluminescente 4 en série avec une résistance 5. Cette diode transforme le signal composite $S_c$ électrique en un signal optique qui est transmis à la partie réception du dispositif à travers une liaison optique 6. La sortie de cette liaison optique débouche sur un transducteur de réception, une photodiode par exemple 7, montée entre une source +V et la terre à travers une résistance 8 qui transforme à nouveau le signal composite optique en un signal électrique composite contenant le signal utile et le signal pilote. Etant donné qu'il est admis que les atténuations subies par le signal pilote sont identiques à celles subies par le signal utile, le signal composite est appliqué à un amplificateur 9 à gain fixe suivi d'un atténuateur numérique 15, ensemble de circuits auquel est connecté un dispositif automatique de commande de gain traitant le signal qu'il a isolé et commandant l'atténuateur de façon que le signal utile qu'il délivre, soit seul, soit encore mélangé au signal pilote ait le niveau requis.

Le dispositif de commande automatique du gain comprend à partir de l'amplificateur à gain fixe 9, un circuit filtre passe bande

10 isolant le signal pilote, un redresseur 11 sans seuil donnant le signal pilote sous forme d'une tension continue, un convertisseur analogique numérique 12 à plusieurs bits suivant la précision requise, un registre tampon 13 et un transcodeur 14. Celui-ci est connecté à l'atténuateur 15 dont il règle l'atténuation. Un filtre passe haut 16 connecté en sortie de l'atténuateur délivre en 17 le signal utile. Une horloge 18 programmateur est prévue pour commander le convertisseur 12, le registre tampon 13 et le transcodeur 14.

Dans ce dispositif relevant de l'art antérieur, on a précisé que le signal pilote ou signal de calibrage qui est superposé au signal utile pour donner le signal composite était situé en dehors de la bande passante du signal utile. Dans un grand nombre de cas, la bande passante du signal utile s'étend depuis des fréquences voisines de zéro jusqu'à des fréquences pouvant atteindre plusieurs centaines de mégahertz. Suivant l'art antérieur le signal pilote doit donc être placé soit très bas en fréquence c'est-à-dire avant la fréquence utile la plus faible, soit très haut après la fréquence utile la plus haute. Ce choix risque de compliquer les circuits électroniques et de limiter soit vers le haut, soit vers le bas la bande passante du signal utile.

On a pu remédier à cet inconvénient en transmettant le signal de calibrage placé dans le spectre utile, de façon périodique, en l'absence du signal utile.

On a constaté toutefois qu'avec des sources lumineuses puissantes du type laser par exemple et avec des liaisons de bonne qualité, la photodiode de détection risquait de recevoir une puissance excédant ses possibilités et que l'atténuation excercée en un point de la chaîne situé derrière cette photodiode, ne constituait pas une protection.

Un objet de la présente invention est alors la définition de moyens permettant l'élimination de cet inconvénient par la recherche d'une atténuation déterminée en amont de la photodiode.

Suivant l'invention, un dispositif de contrôle automatique de gain à action optique dans un système de transmission de signaux

électriques par liaison optique, transmettant un signal électrique de niveau inconnu avec un signal de calibrage de niveau connu, dans la liaison optique disposée entre une diode d'émission transformant les signaux électriques utile et de calibrage qui lui sont appliqués en des signaux optiques et une photodiode retransformant ces signaux optiques en signaux électriques, à une voie de réception située derrière la photodiode comprend un dispositif d'atténuation optique à opacité variable disposé dans la liaison optique, en amont de la photodiode et un dispositif de commande de cet atténuateur inséré dans une boucle de contre réaction établie à partir de la sortie de la liaison optique.

D'autres avantages et caractéristiques de l'invention apparaîtront au cours de la description d'exemples de réalisation, donnés à l'aide des figures qui représentent outre la figure 1 :

- la figure 2, un exemple de réalisation du dispositif de contrôle automatique du gain à action optique suivant l'invention ;

- la figure 3, un exemple de circuit de commande du dispositif ;

- la figure 4, la boucle de contre réaction du dispositif avec une mémoire analogique ;

- la figure 5, la boucle de contre réaction du dispositif avec une mémoire numérique ;

- la figure 6, un exemple de réalisation d'un atténuateur optique utilisé dans le dispositif suivant l'invention, et

- la figure 7, un diagramme montrant la variation de l'angle de polarisation et de la transmission de la lumière en fonction de la tension appliquée dans un atténuateur optique à cristal liquide.

On a vu dans l'introduction à la présente description que dans des systèmes de transmission électriques, relevant du domaine de l'électronique rapide, il était particulièrement judicieux de transformer les signaux à transmettre en des signaux optiques, dont la transmission se faisait par des voies optiques en particulier des fibres s'étendant entre une diode émettrice de type laser par exemple et une photodiode de réception transformant les signaux

optiques en des signaux électriques. Pour connaître le niveau du signal utile transmis, signal très souvent non répétitif, on disposait un dispositif de contrôle automatique du gain de la voie de transmission optique, commandé par un signal de calibrage transmis, de la façon indiquée, comme le signal utile. On a vu toutefois, que suivant l'art antérieur, ce dispositif de contrôle automatique est disposé derrière la photodiode, organe de sortie de la voie optique de transmission et que, dans ces conditions, il ne permettait pas d'assurer la protection de cette photodiode de détection, quand le signal utile transporte une énergie importante ou également quand la liaison optique est à faible perte.

L'atténuation qu'il est nécessaire d'effectuer pour remédier au risque de destruction de la photodiode de détection, doit donc être réalisée en amont de cette photodiode. Etant donné les conditions dans lesquelles s'effectue la transmission, cette atténuation est réalisée de façon optique.

Suivant l'invention, on réalise donc un dispositif de contrôle automatique du gain avec un atténuateur optique, à commande électrique, permettant d'effectuer un asservissement de niveau.

Un atténuateur utilisable suivant l'invention est constitué par un film de cristal liquide inséré entre deux feuilles transparentes, du verre par exemple, que l'on dispose entre deux tronçons d'une fibre optique.

Le fonctionnement d'un tel atténuateur est basé sur la propriété que présentent les cristaux liquides, qu'ils soient de type nématique ou de type cholestérique, d'être plus ou moins transparents à la lumière en fonction d'une tension continue ou alternative qui leur est appliquée.

La figure 6 représente de façon schématique un atténuateur à film de cristaux liquides nématiques du type torsadés ou twistés ou encore en hélice. Il comprend un film 39 de cristal liquide nématique torsadé introduit entre deux lames de verre 40, 41 recouvertes d'un film conducteur transparent 42, 43, d'un mélange d'oxyde d'étain et d'indium. Ces films conducteurs se trouvent en contact avec le film

de cristal liquide et servent à l'établissement d'un champ électrique à l'intérieur du cristal, qui en modifiera les propriétés de rotation de la lumière polarisée de façon continue de 0 à 90°. Ces films conducteurs 42, 43 sont reliés par collage à des bornes 44, 45 entre lesquelles on applique une différence de potentiel. L'épaisseur du cristal liquide est assurée par exemple par une cale de mylar, 46, est de l'ordre de 10 à 20 µm.

Dans son utilisation comme atténuateur, suivant l'invention, le dispositif ou cellule qui vient d'être décrit est placé entre deux polariseurs 47, 48. Ces polariseurs peuvent être parallèles et la cellule est alors obscure au repos et transparente lorsque le champ est établi entre ses électrodes, ils peuvent être croisés et la cellule est alors transparente au repos et obscure sous l'action du champ électrique. On pourra noter à titre d'exemple, que dans une telle cellule, la rotation du plan de polarisation de la lumière entre 90° et 0° s'établit sous une commande passant de 3 volts efficaces à 6 volts efficaces.

La figure 7 indique la variation de l'angle de polarisation $\theta$ (courbe C) et la transmission T de la lumière (courbe D) dans l'atténuateur de la figure 6, en fonction de la tension de commande appliquée.

Une autre propriété des cristaux liquides nématiques peut être mise à profit pour réaliser une cellule d'atténuation utilisable suivant l'invention ; cette propriété est la diffusion dynamique connue sous son abréviation anglo saxonne DSM pour "Dynamic Scattering Mode". La représentation schématique d'un tel atténuateur ne diffère pas beaucoup de la précédente donnée figure 6, dans laquelle on a supprimé les polariseurs. Une telle cellule transmet parfaitement la lumière en l'absence de champ d'excitation ; lorsque le champ est appliqué la cellule commence à diffuser la lumière suivant un angle dépendant de la tension appliquée et de ce fait la lumière qui sort de la cellule dans l'axe de la lumière incidente diminue. Ce type d'atténuation convient particulièrement bien aux fibres optiques ayant une ouverture numérique,

c'est-à-dire, un angle d'acceptance très faible, de sorte que la fraction de lumière diffusée ne puisse être transmise par la fibre. La construction d'un atténuateur conforme à ce qui précède est donnée ci-dessous à titre d'exemple. Deux plaques de verre recouvertes d'un oxyde d'étain et d'indium sont taillées aux dimensions requises, l'une d'entre elles étant percée d'un trou permettant ultérieurement l'injection du cristal liquide. La périphérie de ces plaques est enduite de colle permettant leur application l'une contre l'autre tout en ménageant un espace suffisant pour le film de cristal. Les électrodes sont recouvertes d'un agent mouillant favorisant l'alignement des molécules du cristal liquide sur les deux surfaces en regard. Les lames sont ensuite collées sous vide, le cristal liquide est injecté par le trou prévu à cet effet dans l'une des lames et le trou est ensuite obturé. La cellule est achevée par le collage des bornes de contact et éventuellement par le collage de deux feuilles polarisantes infrarouge.

Les différents types d'atténuation qui ont été cités, le sont à titre d'exemple, tout autre phénomène d'opacité variable obtenu avec les cristaux liquides pouvant être utilisé pour obtenir, suivant l'invention, l'atténuation variable de la lumière transmise.

Les avantages que l'on peut tirer d'un tel atténuateur optique sont une grande dynamique de l'ordre de 20 à 30 dB optique, supérieure à celle de l'atténuateur électrique et le fait qu'il est réalisé en éléments solides assure une bonne fiabilité.

La figure 2 représente un exemple de réalisation du dispositif de contrôle automatique du gain à action optique suivant l'invention avec un dispositif d'atténuation à opacité variable du type à cristal liquide.

Le système dans lequel est introduit le dispositif suivant l'invention comporte une partie génération de signaux et transmission par voie optique des signaux électriques transformés en signaux optiques semblables à celle décrite dans la figure 1 relevant de l'art antérieur. Le circuit 1 désigne dans ces conditions le capteur recevant le signal utile à étudier. Le circuit 2 désigne le générateur

de signal de calibrage. Ces deux circuits sont connectés à un modulateur 3 dans lequel les signaux utiles $S_u$ et de calibrage $S_p$ sont superposés et appliqués à une diode électroluminescente ou laser 4 qui les transforme en un signal lumineux, transportant une certaine puissance $P_E$ qui transite dans la liaison optique 6 constituée par des fibres optiques. La sortie de la voie de transmission optique est appliquée à une photodiode 7 qui alimente un amplificateur vidéofréquence 9 qui fournit le signal de sortie.

Le système de transmission comprend également, en sortie de l'amplificateur vidéo 9, un détecteur de crête 20, suivi d'un amplificateur différentiel 21 dont l'entrée négative est connectée à une source de référence 22. Cet amplificateur différentiel 21 est connecté à un dispositif de commande électrique 23 de l'atténuateur à cristaux liquides 24, inséré dans la liaison optique à fibres dont il doit régler l'atténuation optique.

Le fonctionnement d'un tel système est le suivant :

Le signal utile délivré par le capteur 1 présente une certaine tension $V_u$ qui est liée à la puissance $P_E$ délivrée par la diode laser 4 qui transforme le signal utile sous forme électrique, en un signal optique, facilement transmis par la liaison optique 6 à fibres. Cette relation peut s'écrire :

(1) $P_E = \alpha V_u$, $\alpha$

étant une constante dépendant du gain du modulateur 3 et du rendement de la diode d'émission 4.

Lorsque le signal utile est remplacé par le signal de calibrage qui, on le rappelle, peut être envoyé concomitamment avec le signal utile, soit indépendamment de lui, mais qui suit exactement la même voie de transmission que lui, la puissance émise pource signal de calibrage est

(2) $(P_E)_c = \alpha V_c$,

$V_c$ étant alors la tension du signal de calibrage délivré par le générateur 2. D'après ce qui précède il est évident que dans les deux formules, la constante $\alpha$ est la même.

Le signal transportant la puissance de calibrage est transmis par la liaison optique 6 avec une certaine atténuation et arrive de ce fait à l'atténuateur optique 24 disposé sur cette liaison avec une valeur qui peut être exprimée par l'équation :

(3) $(P_R)_C = (P_E)_C \cdot \beta = \alpha \cdot \beta \cdot V_C$

la constante $\beta$ étant le coefficient d'atténuation optique de la liaison optique.

L'atténuateur optique 24, à cristaux liquides diminue l'intensité lumineuse qui la traverse dans un rapport K, facteur lié à sa tension de commande délivrée par le dispositif de commande 23. A la sortie de l'atténuateur 24, la puissance lumineuse qui sera transmise à la photodiode 7 est exprimée de la façon suivante :

(4) $(P_R)_C \cdot K = \alpha \cdot \beta \cdot K \cdot V_C$.

Cette puissance lumineuse atténuée par rapport à la puissance d'origine est appliquée, dans des conditions de sécurité satisfaisantes, à la photodiode 7 qui effectue une conversion puissance courant avec une pente g.

(5) $I = g \cdot (P_R)_C \cdot K$.

La résistance 8 de valeur R placée en série avec la photodiode 7 transforme ce courant I en une tension crête :

(6) $V' = RI = R \cdot g \cdot (P_R)_C \cdot K$

qui est amplifié dans l'amplificateur vidéo 9 de gain A' qui délivre une tension $V_2 = R \cdot g \cdot (P_R)_C \cdot KA'$.

Cette tension est appliquée au détecteur de valeur crête 20 délivrant une tension continue de même valeur qui est appliquée à la borne positive de l'amplificateur différentiel de gain A dans lequel elle est comparée à une valeur de tension de référence 22, soit Vref.

La tension de sortie $V_S$ de l'amplificateur 21 est :

(7) $V_S = \left[R \cdot g \cdot (P_R)_C \cdot KA' - Vref\right] A$.

Cette tension $V_S$ est la tension de commande des cristaux liquides de l'atténuateur 24.

Si l'atténuation K introduite par la feuille de cristaux liquides 24 est liée à sa tension de commande par le facteur $\eta$, on peut

écrire :

(8) $\left[R \cdot g \cdot (P_R)_c KA' - Vref\right] A \eta = K$

ou encore :

$\left[R \cdot g \cdot (P_R)_c A'A \eta - 1\right] K = Vref\ A \eta$

d'où

(9) $K = \dfrac{Vref \cdot A\eta}{A'R \cdot g \cdot (P_R)_c A\eta - 1}$

Dans ces conditions la tension $V_2$ à la sortie de l'amplificateur vidéo 9 devient :

(10) $V_2 = A'RI = A'R \cdot g \cdot (P_R)_c \dfrac{Vref \cdot A\eta}{A'R \cdot g \cdot (P_R)_c A\eta - 1}$

si le gain des amplificateurs est suffisant pour que l'expression $R \cdot g \cdot (P_R)_c A'A \eta$ soit beaucoup plus grande que 1, on peut écrire :

$$V_2 = R \cdot g \cdot (P_R)_c \frac{A'\ Vref \cdot A\eta}{A'R \cdot g \cdot (P_R)_c A\eta} = Vref$$

On conçoit dans ces conditions que quelles que soient les atténuations optiques sur la ligne, la chaîne de contre réaction établie à partir de l'amplificateur vidéo 9 est telle que l'on obtient un signal correspondant au signal de calibrage égal à la tension de référence.

Si le réglage du dispositif de contrôle automatique du gain est maintenu tel pour le signal utile, ce dernier présentera un niveau : $\dfrac{V_u}{V_c} Vref = V_{uM}$, signal utile mesuré au sortir de l'amplificateur vidéo 9.

Connaissant donc le niveau du signal utile à la sortie de la liaison optique, on en peut déduire sa valeur à l'entrée de la chaîne soit

$$V_u = \frac{V_c}{Vref} \cdot V_{uM}.$$

La chaîne de contre réaction, pour un fonctionnement correct, doit répondre seulement au signal de calibrage. Le signal de calibrage comme cela a été déjà signalé peut se situer à l'extérieur de la bande passante du signal utile. Il est alors isolé à la sortie de

l'amplificateur vidéo 9, par un filtre passe bande 25 représenté en point-traits, introduit entre l'amplificateur 9 et le détecteur vidéo 20. Le filtre est centré sur la fréquence du signal de calibrage.

La commande des cristaux liquides est généralement réalisée en alternatif basse fréquence, en modulant l'amplitude d'une tension alternative.

La figure 3 donne un exemple de réalisation de cette commande. Comme modulateur on utilise un multiplicateur analogique 26 effectuant le produit entre un signal alternatif d'amplitude constante délivré par un oscillateur basse fréquence 27 et le signal continu de commande provenant de l'amplificateur différentiel 21 (figure 2).

Le signal de calibrage peut également être placé dans le spectre du signal utile, ce qui permet, comme cela a été déjà dit, d'élargir la bande de mesure. Ce signal de calibrage est alors utilisé avant une mesure. Le filtre passe-bande 25 n'est plus nécessaire, mais par contre la boucle de contre réaction doit comporter un élément de mémoire permettant de conserver les réglages du contrôle automatique de gain après chaque calibrage, dans l'attente du signal utile.

Cette mémoire peut être analogique ou numérique.

La figure 4 représente la boucle de contre réaction du système de la figure 2 avec une mémoire analogique ; cette mémoire analogique 28 se présente sous la forme d'un échantillonneur bloqueur en sorite de l'amplificateur différentiel 21.

Cet échantillonneur bloqueur comporte un condensateur 29 en série avec un interrupteur électrique ou électronique 30, disposé entre deux amplificateurs tampon 31 et 32.

Quand il est demandé d'effectuer un calibrage nécessitant le positionnement de l'atténuateur variable 24, on envoie une impulsion 33 commandant la fermeture de l'interrupteur 30 et de ce fait la charge du condensateur 29, à une tension correspondant à la commande correcte de l'atténuateur (phase échantillonnage). L'impulsion de commande appliquée doit avoir une durée suffisante

pour permettre à l'asservissement d'atteindre son état d'équilibre.

L'interrupteur 30 est alors ouvert, mais l'impédance de l'amplificateur 32 qui suit le condensateur 29 étant très grande, celui-ci ne se décharge pas immédiatement, pouvant maintenir sa charge pendant un laps de temps pouvant atteindre plusieurs minutes (phase blocage).

La figure 5 représente la boucle de contre réaction du système de la figure 2 avec une mémoire numérique. Celle-ci, 34, se présente sous la forme d'un ensemble comprenant un convertisseur analogique numérique 35, un registre mémoire 36 et un convertisseur numérique analogique 37. Une horloge 38 est prévue pour commander la mémoire qui est introduite entre l'amplificateur différentiel 21 et la commande 23 de l'atténuateur optique 24.

A chaque top de l'horloge 38, le signal sortant de l'amplificateur différentiel 21 est converti en un mot numérique dont les différents digits sont enregistrés dans le registre 36. Le mot numérique est ensuite reconverti en un signal analogique dans le convertisseur 37 et appliqué au circuit de commande 23. L'horloge 38 ne fonctionne que pendant un temps jugé suffisant pour que l'asservissement atteigne son état d'équilibre. A ce moment, l'horloge est arrêtée et le signal de commande correcte de l'atténuateur 24 est conservé dans la mémoire numérique constituée par le registre 36.

On a ainsi décrit un dispositif de contrôle automatique du gain à action optique dans un système de transmission de signaux électriques par liaison optique.

## REVENDICATIONS

1. Dispositif de contrôle automatique de gain à action optique dans un système de transmission de signaux électriques par liaison optique transmettant un signal électrique de niveau inconnu avec un signal de calibrage de niveau connu dans la liaison optique disposée entre une diode d'émission transformant les signaux électriques utiles et de calibrage qui lui sont appliqués en des signaux optiques et une photodiode retransformant ces signaux optiques en signaux électriques, à une voie de réception située derrière la photodiode, caractérisé par le fait qu'il comprend un dispositif d'atténuation optique à opacité variable (24) disposé dans la liaison optique (6) en amont de la photodiode (7) et un dispositif de commande (23) de cet atténuateur optique inséré dans une boucle de contre réaction établie à partir de la sortie de la liaison optique.

2. Dispositif de contrôle suivant la revendication 1, caractérisé par le fait que l'atténuateur optique est constitué par un film (24) de cristal liquide dont l'opacité variable est commandée par un dispositif de commande électrique (23).

3. Dispositif de contrôle suivant l'une des revendications 1 ou 2, caractérisé par le fait que la commande électrique (23) de l'atténuateur (24) à opacité variable est introduite dans un circuit de contre réaction sensible au signal de calibrage, établi à la sortie de l'amplificateur vidéo (9) recevant les signaux électriques utile et de calibrage délivrés par la photodiode (7) de sortie de la liaison optique (6) et comprenant, un détecteur de crête (20), un amplificateur différentiel (21), le circuit de commande (23) de l'atténuateur et l'atténuateur (24) disposé dans la liaison optique (6).

4. Dispositif de contrôle suivant la revendication 3, caractérisé par le fait qu'il comprend un filtre passe bande (25) centré sur la fréquence du signal de calibrage, introduit dans la chaîne de contre réaction entre la sortie de l'amplificateur vidéo (9) et le détecteur de crête (20).

5. Dispositif de contrôle suivant la revendication 3, caractérisé par le fait que le circuit de commande (23) de l'atténuateur à opacité variable est constitué par un multiplicateur (26) connecté à un oscillateur basse fréquence (27) et à l'amplificateur différentiel (22).

6. Dispositif de contrôle suivant la revendication 3, caractérisé par le fait que, lorsque le signal de calibrage est placé dans le spectre du signal utile, un circuit mémoire (28, 34) est introduit entre l'amplificateur différentiel (21) et le circuit de commande (23) de l'atténuateur (24).

7. Dispositif de contrôle suivant la revendication 6, caractérisé par le fait que le circuit mémoire (28) est analogique comprenant un condensateur (29) en série avec un interrupteur (30) disposé entre deux amplificateurs tampon (31-32).

8. Dispositif de contrôle suivant la revendication 6, caractérisé par le fait que le circuit mémoire (34) est numérique, comprenant un convertisseur analogique numérique (35), un registre mémoire (35) et un convertisseur numérique analogique (37), commandés par une horloge (38).

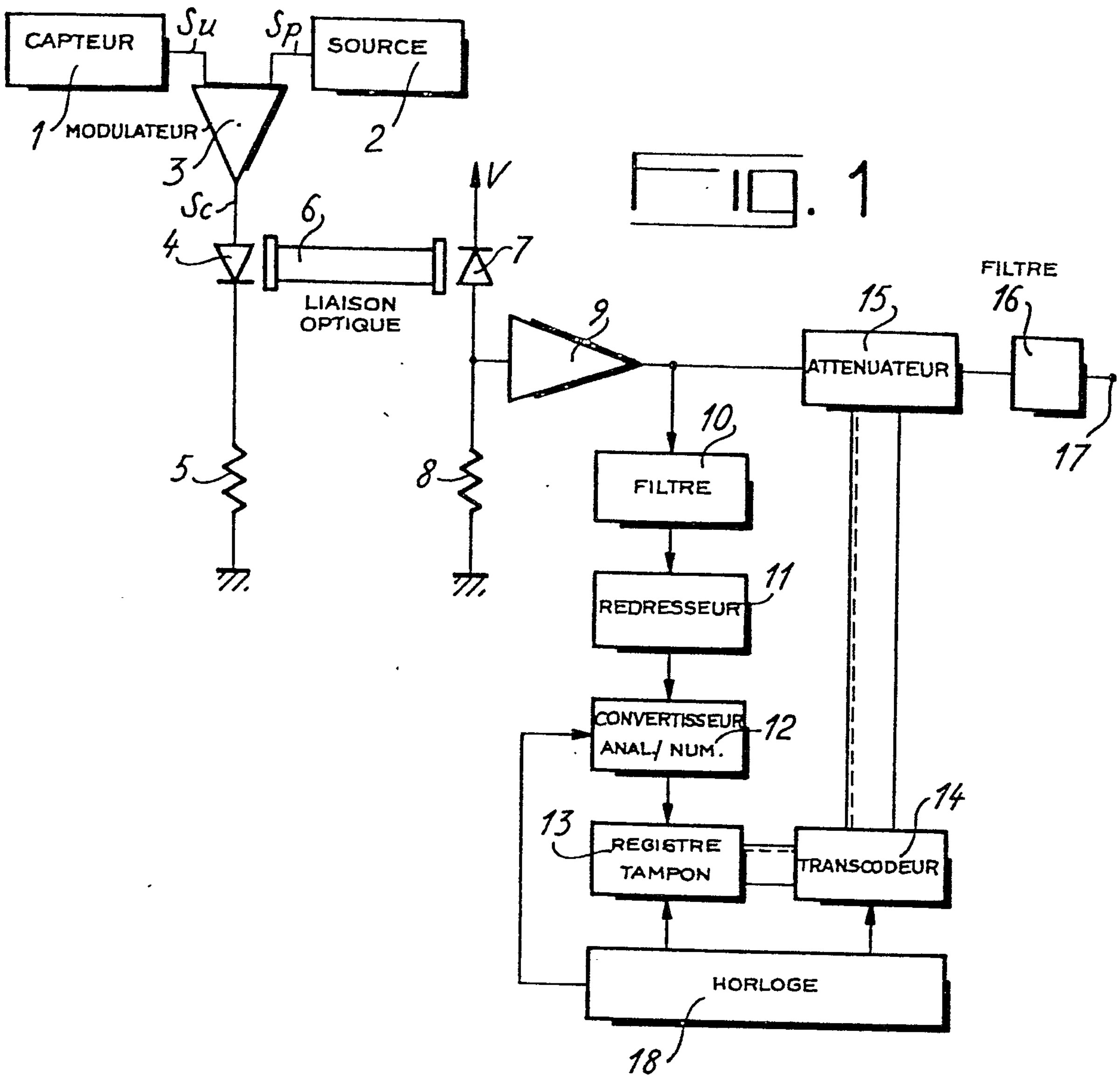
CAPTEUR
Su
Sp
SOURCE
1
MODULATEUR
2
3
Sc
6
4
7
V
LIAISON
OPTIQUE
9
15
FILTRE
16
ATTENUATEUR
17
10
5
8
FILTRE
REDRESSEUR
11
CONVERTISSEUR
ANAL./ NUM.
12
13
14
REGISTRE
TAMPON
TRANSCODEUR
HORLOGE
18

FIG. 1

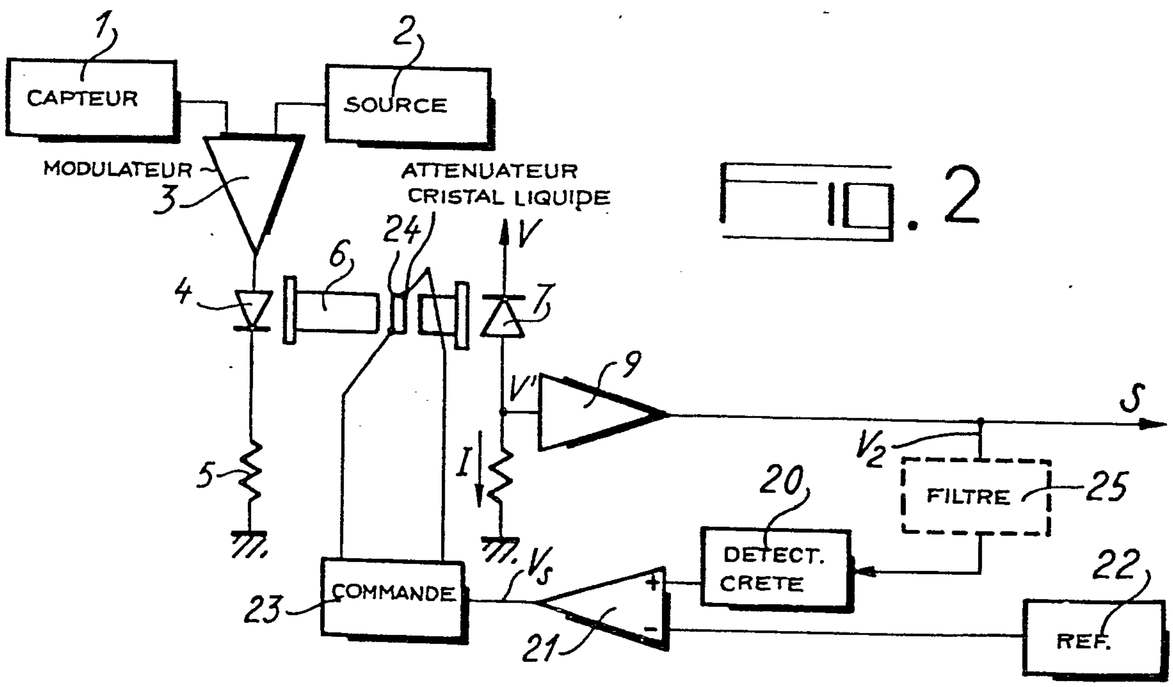
1
2
CAPTEUR
SOURCE
MODULATEUR
3
ATTENUATEUR
CRISTAL LIQUIDE
24
V
6
4
7
9
V'
S
V2
I
5
20
25
FILTRE
DETECT.
CRETE
Vs
22
COMMANDE
23
21
REF.

FIG. 2

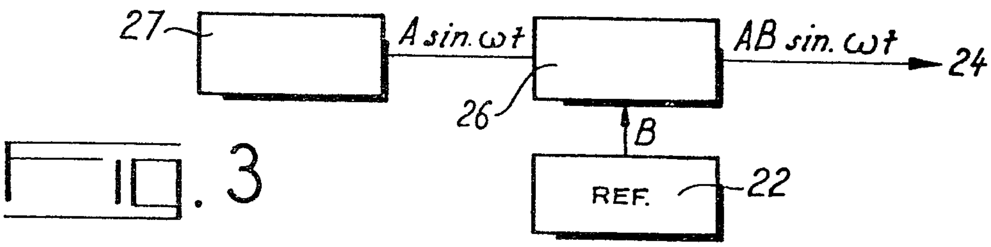


FIG. 3

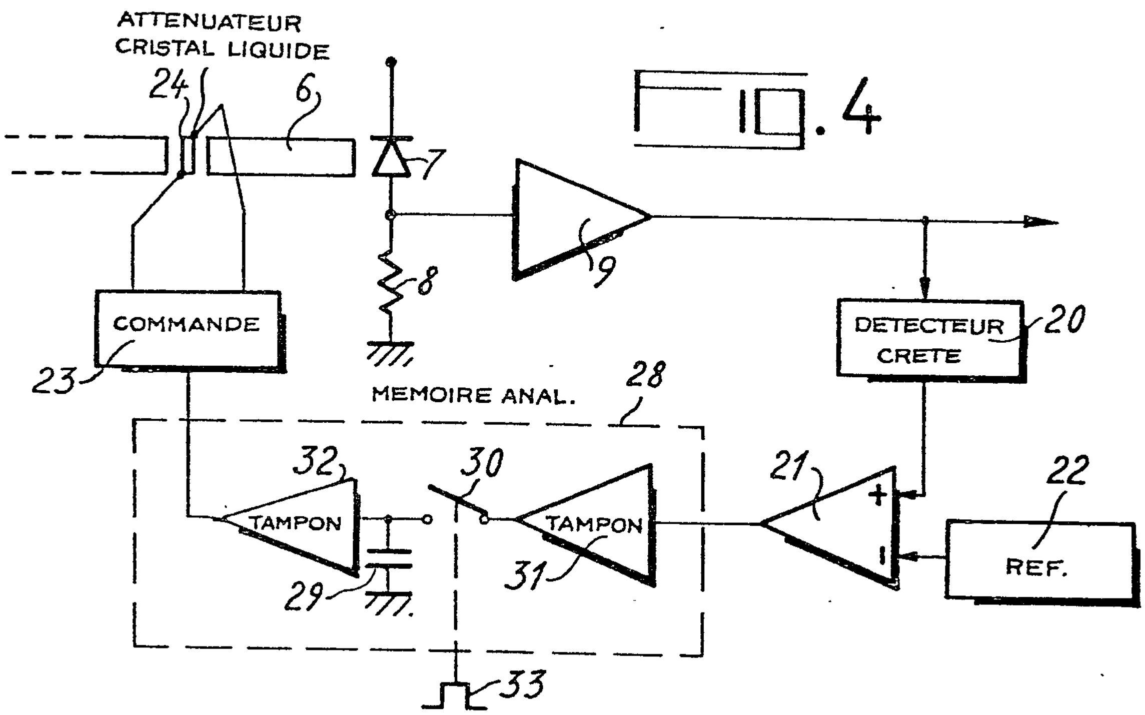


FIG. 4

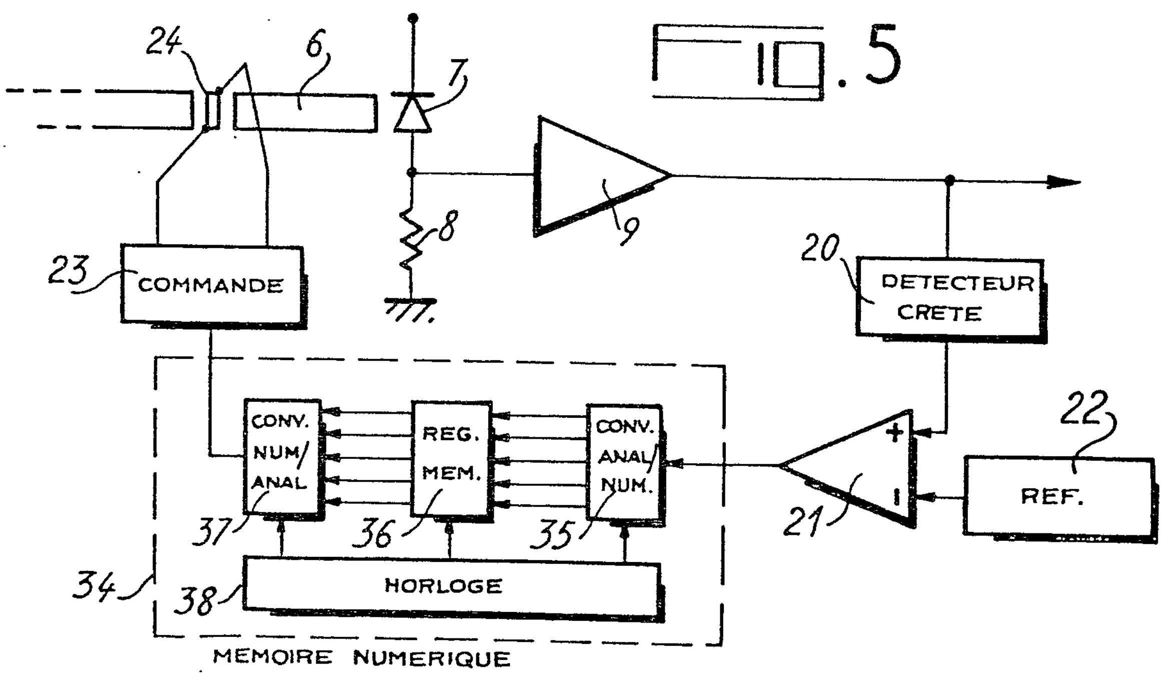


FIG. 5

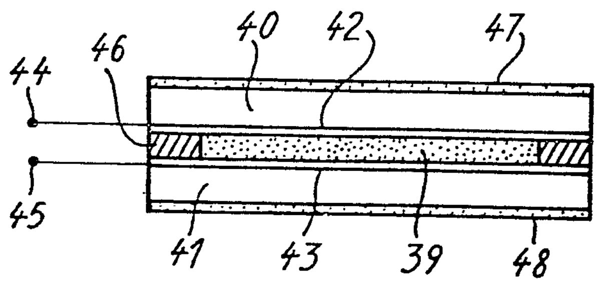


FIG. 6

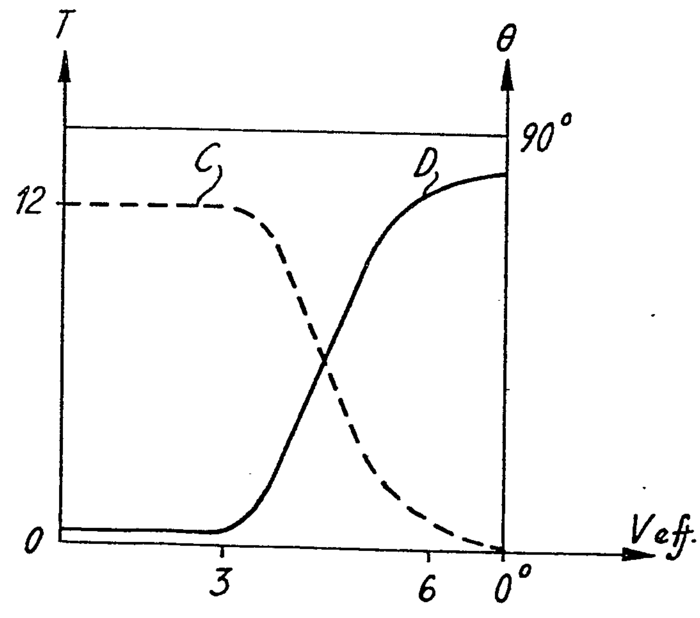


FIG. 7

0027758

Numéro de la demande

Office européen des brevets

# RAPPORT DE RECHERCHE EUROPEENNE

EP 80 40 1426

| Catégorie | DOCUMENTS CONSIDERES COMME PERTINENTS<br>Citation du document avec indication, en cas de besoin, des parties pertinentes | Revendication concernée | CLASSEMENT DE LA DEMANDE (Int. Cl. 3) |
|---|---|---|---|
| X | ELECTRONICS LETTERS, vol. 15, no. 5, 1er mars 1979<br>LONDRES (GB)<br>EVE et SMITH: "New automatic-gain-control system for optical receivers", pages 146-147.<br>* en entier *<br>-- | 1-3,5 | H 03 G 3/20 |
| X | IEEE TRANSACTIONS ON AEROSPACE AND ELECTRONIC SYSTEMS, vol. AES-5, no. 3, mai 1969<br>NEW YORK (US)<br>R.P. RUFER: "An Electrooptical Automatic Gain Control", pages 463-473.<br>* pages 463-464; figures 1-3 *<br>-- | 1 | DOMAINES TECHNIQUES RECHERCHES (Int. Cl. 3)<br>H 03 G<br>G 02 F |
| | DE - A - 2 165 503 (R.M. LEUZE)<br>* figure 1; page 3, alinéa 1 à page 5, dernière ligne *<br>-- | 1,2 | |
| | FR - A - 2 361 022 (SOC. NAT. IND. AEROSPATIALE)<br>* figure unique; page 6, ligne 1 à page 9, ligne 22 *<br>-- | 1,3,4 | CATEGORIE DES DOCUMENTS CITES<br>X: particulièrement pertinent<br>A: arrière-plan technologique<br>O: divulgation non-écrite<br>P: document intercalaire<br>T: théorie ou principe à la base de l'invention<br>E: demande faisant interférence<br>D: document cité dans la demande<br>L: document cité pour d'autres raisons |
| | APPLIED OPTICS, vol. 15, no. 5, mai 1976<br>NEW YORK (US)<br>EGBERT et al.: "Pulsed dye laser applied to modulated spectroscopy magnetic circular dichroism", pages 1158-1163.<br>* figures 1,8 et 9; page 1161, en entier * -- ./.. | 1,6,7 | |
| X | Le présent rapport de recherche a été établi pour toutes les revendications | | &: membre de la même famille, document correspondant |

| Lieu de la recherche | Date d'achèvement de la recherche | Examinateur |
|---|---|---|
| La Haye | 20-01-1981 | GYSEN |

OEB Form 1503.1 06.78

BAD ORIGINAL

0027758

Office européen des brevets

RAPPORT DE RECHERCHE EUROPEENNE

Numéro de la demande

EP 80 40 1426

| DOCUMENTS CONSIDERES COMME PERTINENTS | | | CLASSEMENT DE LA DEMANDE (Int. Cl. 3) |
|---|---|---|---|
| Catégorie | Citation du document avec indication, en cas de besoin, des parties pertinentes | Revendication concernée | |
| A | US - A - 4 070 572 (SUMMERHAYES)<br>* figure 3; colonne 5, lignes 1-34 *<br>----- | 1 | |
| | | | DOMAINES TECHNIQUES RECHERCHES (Int. Cl. 3) |

OEB Form 1503.2 06.78